## Europäisches Patentamt
## European Patent Office
## Office européen des brevets

(19)

(11) Publication number: **0 041 770**
A2

(12)

# EUROPEAN PATENT APPLICATION

(21) Application number: **81301790.2**

(22) Date of filing: **23.04.81**

(51) Int. Cl.³: **G 11 C 17/00**
**H 01 L 27/10**

(30) Priority: **23.05.80 US 153463**

(43) Date of publication of application:
**16.12.81 Bulletin 81/50**

(84) Designated Contracting States:
**DE FR GB**

(71) Applicant: TEXAS INSTRUMENTS INCORPORATED
13500 North Central Expressway
Dallas Texas 75265(US)

(72) Inventor: Possley, Glen Gray
1338 Laramie Pl.
Lewisville Texas 75067(US)

(72) Inventor: Wilson, Earl Cecil
882 N. Wilcrest
Houston Texas 77079(US)

(74) Representative: Abbott, David John et al,
Abel & Imray Northumberland House 303-306 High
Holborn
London, WC1V 7LH(GB)

(54) A programmable read-only-memory element and method of fabrication thereof.

(57) A programmable read-only-memory (PROM) element is disclosed in which an N-type epitaxial layer, grown on a P-type substrate with an N + buried layer therebetween, has a P-type anode region formed in a surface portion thereof. An N-type poly-silicon layer is formed on the surface of the anode region, generally within an aperture in an insulating layer, with the dopant of the poly-silicon layer being diffused downwardly into the anode region to form a shallow N-type cathode region. A metal layer is deposited on the surface of the poly-silicon layer over the anode region, and a low resistivity path is provided to the buried layer. To program the memory element, a positive potential is applied to the metal layer relative to the buried layer to break down the barrier between the cathode and anode regions. As the reverse current flow heats the poly-silicon. the metal alloys through the poly-silicon and the cathode region, and shorts to the anode region.

Fig. 1b

A PROGRAMMABLE READ-ONLY-MEMORY ELEMENT AND METHOD OF FABRICATION THEREOF

FIELD OF THE INVENTION

This invention relates generally to semiconductor programmable read-only-memories (PROMs), and more particularly to a programmable read-only-memory element having a vertical structure.

PRIOR ART STATEMENT

Generally, monolithic semiconductor read-only-memory (ROM) devices are programmed during the manufacturing process, by building the program into the structure of an array of memory elements. Once manufactured, the program in the ROM cannot be altered or changed, since such changes require modifications to the programming masks employed during fabrication. In addition, the cost of manufacturing a ROM to a particular customer's requirements is large and economically prohibitive unless a large number of devices with the same ROM program are manufactured. These problems led to the development of the programmable read-only-memory (PROM) in which the manufacturer uses a standard process for all parts, and the customer programs the individual parts as desired. Generally, such PROMs use relatively large metallic fusible links that are melted or vaporized to create an open circuit. However, the relatively high level of programming current required by such devices demands high-power programming transistors which tend to be both slow and space consuming. Another problem with present PROMs is that the fusible link will someitmes "grow back" and thus change the ROM code.

SUMMARY OF THE INVENTION

A programmable read-only-memory element is fabricated by forming a P-type anode region in a surface portion of an N-type epitaxial layer which has been grown on a P-type

- 2 -

substrate with an N+ buried layer therebetween. An N+ polycrystalline silicon layer is formed on the surface of the anode region via an aperture in an insulating layer deposited on the surface of the epitaxial layer. The dopant of the poly-silicon layer is diffused downward into the surface of the anode region to form a shallow cathode region. A metal layer is deposited on the surface of the poly-silicon layer over the anode region and a low resistivity path is provided to the buried layer. To program a memory element, a positive potential is applied to the metal layer relative to the buried layer to break down the barrier between the cathode and anode regions. As the reverse current flow heats the poly-silicon, the metal alloys therethrough and shorts to the anode region.

One object of the present invention is to provide a programmable read-only-memory element requiring a relatively low level of programming current.

Another object of the present invention is to provide a programmable read-only-memory having a relatively small cell size.

One other object of the present invention is to provide a programmable read-only-memory element having improved reliability through elimination of fuse "grow back".

Other objects and advantages of the present invention will be evident from the following detailed description when read in conjunction with the accompanying drawings which illustrate one preferred embodiment thereof.

BRIEF DESCRIPTION OF THE DRAWINGS

FIGURE la is a plan view of a programmable read-only-memory element constructed in accordance with the preferred embodiment of the present invention.

FIGURE 1b is a cross-sectional view of the memory element of Figure la taken along the line lb-lb therein.

FIGURE 1c is an electrical schematic representation of the memory element of Figures la and lb.

- 3 -

FIGURE 2 is an electrical schematic of a memory system having an array of the memory elements of Figure 1.

DESCRIPTION OF THE PREFERRED EMBODIMENT

In the preferred method for fabricating the programmable read-only-memory (PROM) element 10 shown in Figures la and lb, a P-type monocrystalline silicon substrate 12 of 10-20 ohm-cm cut on the 100 orientation has a major surface 14 thereof oxidized and patterned to receive an arsenic implant which forms a buried layer 16 with a relatively low resistivity of the order of 15-25 ohms/square and a depth of about 4-10 microns. Following oxide removal, an N-type epitaxial layer 18 having a resistivity of 0.5-2.5 ohm-cm is grown on the surface 14 of the substrate 12 to a thickenss of 1-3 microns. Selected portions of the epitaxial layer 18 are then removed, and the remaining portions oxidized to form an oxide insulating layer 20 having conventional oxide isolation regions 22. After the insulating layer 20 has been selectively removed to expose the surface of the epitaxial layer 18, a P-type anode region 24 is formed by a boron implant dose on the order of $8 \times 10^{14}$ ions/cm$^2$ at 90 KeV, so that the anode region 24 will have a resistance of 17--230 ohms/square and a depth of 0.6-0.8 microns following heat treatment. Following further oxidation and patterning, deep phosphorus diffusions (not shown) are formed in the surface of the epitaxial layer 18 to provide a low resistivity path to the buried layer 16. After removal of the diffusion debris, an aperture 26 is made in the insulating layer 20 over the anode region 24. A polycrystalline silicon (poly-silicon) layer 28 is then deposited on the layer 20 and the exposed portions of the anode region 24 to thickness of a out 2400 Angstroms, and subjected to an arsenic implant dose on the order of $3-6 \times 10^{15}$ ions/cm$^2$ at 40-80 KeV. Photoresist (not shown) is then applied and patterned to protect the portion of the poly-silicon layer 28 over the anode region 24, while the remaining portions are removed by plasma etching. After further conventional processing to form the emitters and collectors of the desired control circuitry, oxide is again grown and a contact window 30 formed to expose the surface of the poly-silicon layer 28. A metal layer 32, such as 2 percent copper-doped aluminium, is then deposited to a thickness of about 7000 Angstroms and patterned to leave metal on the portion of the poly-silicon layer 28 over the anode region 24. During these processing steps, a portion of the arsenic implanted into the poly-silicon layer 28 will diffuse downward into the anode region 24 to form a shallow N-type cathode region 34.

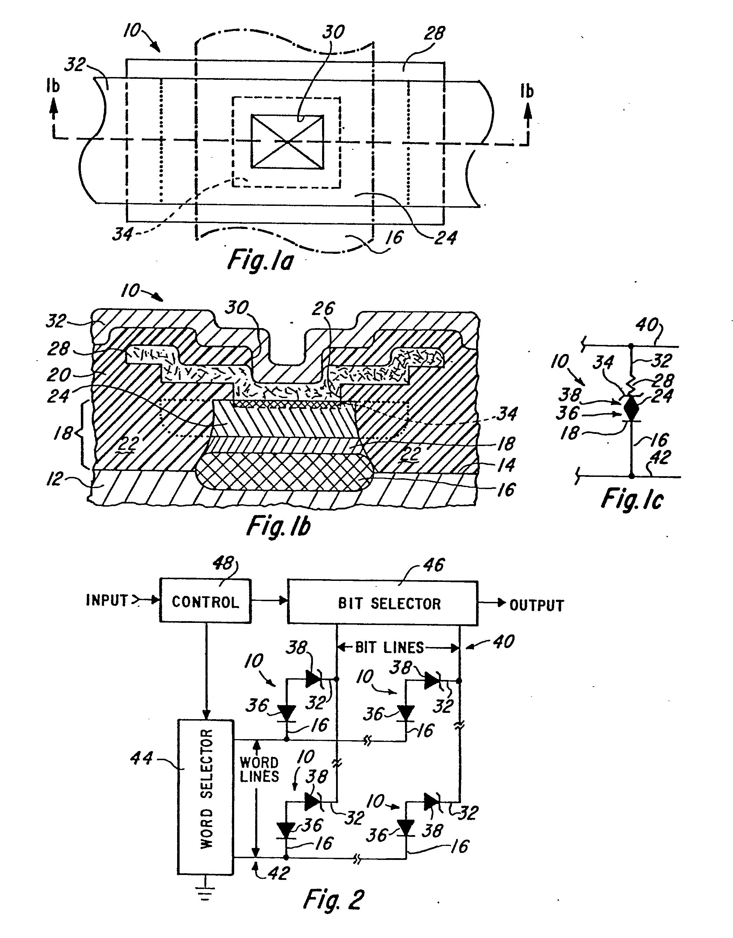

As shown schematically in Figure 1c, the P-N junction at the interface of the anode region 24 and the epitaxial layer 18 forms a decoupling diode 36 relative to the conductive buried layer 16, while the P-N junction at the interface of the anode region 24 and the cathode region 34 forms a programming diode 38 relative to the conductive metal layer 32. Thus, an unprogrammed memory element 10 prevents the flow of current between the metal layer 32 and the buried layer 16, due to the back-to-back configuration of the decoupling and programming diodes 36 and 38, respectively.

In the preferred embodiment, the programming diode 38 has a relatively low breakdown or Zener threshold which, when exceeded, allows current to flow from the metal layer 32 to the buried layer 16 through the relatively high resistivity poly-silicon layer 28. If the level of current exceeds a "programming" level, power dissipation across the P-N junction between the anode region 24 and the cathode region 34 rapidly heats the poly-silicon layer 28 and the overlying metal layer 32, allowing some of the metal comprising the metal layer 32 to alloy or "spike" through into contact with the anode region 24. As soon as the metal shorts to the anode region 25, destroying the programming diode 38, resistive heating effects drop sharply and the migration of the metal soon terminates. Preferably, the depth of the anode region 24 is sufficient to assure that the metal shorts stop well above the P-N junction between the anode region 24 and the epitaxial layer 18. Thus, a programmed memory element 10 allows current flow from the metal layer 32 to the buried layer 16, due to the elimination of the programming diode 32, but not in the reverse direction because of the decoupling diode 36.

When connected in a conventional row-by-column array such as that illustrated in Figure 2, each memory element 10 may have the metal layer 32 thereof integrated into a selected one of a plurality of bit lines 40 and the buried layer 16 thereof integrated into a selected one of a plurality of word lines 42, so that one and only one of the memory elements 10 is coupled between any particular pair of bit and word lines 40 and 42, respectively. In such an arrangement, a desired one of the memory elements 10 may be selectively programmed by applying programming current to the respective bit line 40 while shunting the resepctive word line 42 to ground. Thereafter, the logical condition of the bit of information represented by the programmed memory element 10 will be opposite that of a non-programmed memory element 10. This binary system may be readily utilized to form a complete programmable read-only-memory system by adding conventional word and bit selectors 44 and 46, respectively, which are responsive to a suitable control circuit 48.

In a memory element 10 fabricated using the preferred method described above, a voltage differential on the order of 8 volts between a bit line 40 and a word line 42 has been found to be sufficient to break down the programming diode 38, with a programming current on the order of 20-50 milli-amps being sufficient to effect permanent programming of the . respective memory element 10. Such voltage and current requirements can be satisfied using programming and decoding

- 6 -

transistors which are substantially smaller than in prior art devices.  In addition, the "short circuit" technique employed in the memory element 10 offers improved reliability over prior art fusible metal link PROM elements since the memory element 10 is not subject to the phenomenon of link "grow back".

Although the present invention has been described herein with reference to a preferred embodiment and method for fabrication thereof in an oxide isolated form, conventional P-N junction isolation techniques may be advantageously employed to fabricate the memory element if desired. Various other changes may be made in the construction or arrangement of the parts or elements of the preferred embodiment and method disclosed herein without departing from the spirit and scope of the present invention as defined in the appended claims.

CLAIMS:

1.      A programmable read-only-memory element comprising:

a silicon base of a first conductivity type;

a first region of a second conductivity type formed in a surface portion of the base;

a silicon layer of the first conductivity type on a portion of the surface of the first region; and

a metal layer over said silicon layer.

2.      The memory element of claim 1 further comprising:

a second region of the first conductivity type formed in a surface portion of the first region beneath the silicon layer.

3.      The memory element of claim 1 or 2 wherein the silicon layer is of polycrystalline silicon of said first conductivity type.

4.      The memory element of claim 1 wherein the metal layer is primarily aluminium.

5.      The memory element of claim 1 comprising:

an insulating layer on the surface of the base surrounding the portion of the silicon layer on the surface of the first region.

6.      The memory element of claim 1 wherein the silicon base comprises:

a silicon substrate of the second conductivity type;

an epitaxial layer of silicon of the first conductivity type on a major surface of the substrate; and

a low resistivity region of the first conductivity type formed along the junction of the eiptaxial layer and the substrate.

7.      A programmable read-only-memory element comprising:

a silicon base of a first conductivity type;

a first region of a second conductivity type formed in a surface portion of the base;

-8-

a second region of the first conductivity type formed in a surface portion of the first region;

an insulating layer on said surface, having an aperture which exposes at least a portion of the surface of the second region;

a silicon layer on the surface of the second region within said aperture; and

a metal layer over said silicon layer.

8. The memory element of claim 7 wherein the silicon layer is of polycrystalline silicon of said first conductivity type.

9. The memory element of claim 7 or 8 wherein the metal layer is primarily aluminium.

10. A method for fabricating a programmable read-only-memory element comprising the steps of:

forming a first region of a first conductivity type in a surface portion of a silicon base of a second conductivity type;

forming a silicon layer of the second conductivity type on a portion of the surface of the first region; and

forming a metal layer over said silicon layer.

11. The method of claim 10 further comprising the step of:

forming a second region of the second conductivity type in a surface portion of the first region beneath the silicon layer.

12. The method of claim 9 wherein the step of forming the silicon layer comprises the steps of:

depositing a polycrystalline silicon layer on at least a portion of the surface of the first region; and

implanting said silicon layer with a dopant of said second conductivity type.

13. The method of claim 12 further comprising the step of:

diffusing some of the dopant implanted in said
silicon layer downward into the surface of said first region
to form a second region of said second conductivity type.

Fig. la

Fig. lb

Fig. lc

Fig. 2